(19) Europäisches Patentamt
European Patent Office
Office européen des brevets

(11) **EP 4 216 146 A1**

(12) **EUROPEAN PATENT APPLICATION**
published in accordance with Art. 153(4) EPC

(43) Date of publication:
26.07.2023 Bulletin 2023/30

(51) International Patent Classification (IPC):
**G06Q 50/08** (2012.01) **B66C 13/00** (2006.01)

(21) Application number: **21885939.5**

(52) Cooperative Patent Classification (CPC):
**B66C 13/00; G06Q 50/08**

(22) Date of filing: **15.10.2021**

(86) International application number:
**PCT/JP2021/038280**

(87) International publication number:
**WO 2022/091820 (05.05.2022 Gazette 2022/18)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **02.11.2020 JP 2020183537**

(71) Applicant: KOBELCO CONSTRUCTION
MACHINERY CO., LTD.
**Hiroshima-shi**
**Hiroshima 731-5161 (JP)**

(72) Inventors:
• **MITANI Tomotaka**
**Tokyo 141-8626 (JP)**
• **OKADA Satoshi**
**Tokyo 141-8626 (JP)**
• **TAKAMATSU Nobuhiro**
**Tokyo 141-8626 (JP)**

(74) Representative: **TBK**
**Bavariaring 4-6**
**80336 München (DE)**

(54) **CONSTRUCTION WORK PLANNING SUPPORT DEVICE**

(57) A technology capable of facilitating work of selecting a crane of a type which is appropriate in view of a work site situation is provided. When the crane of the type satisfying specified conditions is present, information regarding the crane of the type is selectively provided to a user such as a construction work planner through a terminal output interface 42. A "first specified condition" included in the specified conditions is the condition of having such a load-lifting level that an interval $C_i$ between an upper end of a building B and a lower end of a material W which is a suspended load is equal to or larger than a threshold $C_{1th}$ in a state where a crane 10 is arranged at a specified place in an area around the building B and an attachment 14 is in a specified posture.

FIG.5

EP 4 216 146 A1

**Description**

Technical Field

The present invention relates to a technology of selecting a type of a crane according to a work site situation.

Background Art

A technology of planning deployment of construction machines at individual bases of a rental company or the like by using a management computer capable of collecting operation time or rental time of construction machines lent from the individual bases has been proposed (for example, see Patent Literature 1). In order to improve productivity and safety for a crane field, BIM (Building Information Modeling) has been adopted. In an execution stage, selection of a heavy machine needed for execution and a lifting plan of a construction machine such as a crane are needed.

Citation List

Patent Literature

Patent Literature 1: Japanese Patent Laid-Open No. 2002-099589

Summary of Invention

Technical Problem

However, work of selecting a type and/or an arrangement location of a crane depends on an experience of a construction work planner. Therefore, depending on the experience of the construction work planner, it is possible that a crane of a type which is inappropriate in view of a work site situation is selected and hindrance is caused in actual work. In addition, when a crane which is excessively large in view of work contents is selected, it is possible that time of deploying the crane at a work site for which a specification of the crane is appropriate is delayed and construction work is delayed or a construction work period is limited.

An object of the present invention is to provide a technology capable of facilitating work of selecting a crane of a type which is appropriate in view of a work site situation.

Solution to Problem

A construction work planning support device of the present invention comprises:

a first planning support processing element configured to recognize a space occupancy mode of a building, topography of an area around the building and a space occupancy mode when lifting a material as a suspended load;

a type selection support processing element configured to determine, based on the space occupancy mode of the building, the topography of a specified place included in the area around the building and the space occupancy mode of the material recognized by the first planning support processing element, presence/absence of a crane of a type satisfying specified conditions including a first specified condition of having such a load-lifting level that an interval between an upper end of the building and a lower end of the material is equal to or larger than a threshold in a state where the crane is arranged at the specified place and an attachment is in a specified posture; and

a second planning support processing element configured to make an output interface output information regarding a determination result by the type selection support processing element.

According to the construction work planning support device of the configuration, the information regarding the determination result for the presence/absence of the crane of the type satisfying the specified conditions is selectively provided to a user such as a construction work planner through an output interface. The presence/absence of the crane of the type is determined in a type group configured by the cranes of the plurality of types determined beforehand. The "first specified condition" included in the specified conditions is the condition of having such a load-lifting level that the interval between the upper end of the building and the lower end of the material which is the suspended load is equal to or larger than the threshold in the state where the crane is arranged at the specified place in the area around the building and the attachment is in the specified posture. Therefore, from the perspective of lifting the material from a material yard of the building or lowering the material down to the material yard of the building while avoiding interference of the building and the material for a height direction in the state where the crane is arranged at the specified place and the attachment is in the specified posture, not only work of selecting the crane of an appropriate type by the user but also work of preparing a construction plan using the crane are facilitated.

"Recognizing" information by a component (hardware resource) of the present invention is a concept including all kinds of information processing of preparing the information in a form utilizable in following arithmetic processing, such as receiving the information, reading the information from a storage device, predicting, determining or estimating the information by executing arithmetic processing based on received information and/or read information and storing the information in the storage device.

In the construction work planning support device of the present invention,
it is preferable that

the type selection support processing element determines, based on the space occupancy mode of the building and a space coordinate value of the specified place recognized by the first planning support processing element, presence/absence of the crane of the type satisfying the specified conditions further including a second specified condition of having a working radius that includes the building in the state where the crane is arranged at the specified place and a posture of the attachment is the specified posture.

According to the construction work planning support device of the configuration, the "second specified condition" included in the specified conditions is the condition of having the working radius that includes the building in the state where the crane is arranged at the specified place in the area around the building and the attachment is in the specified posture. Therefore, from the perspective of moving the material in a horizontal direction to an upper part of the material yard of the building or moving the material in the horizontal direction from the upper part of the material yard of the building in the state where the crane is arranged at the specified place and the attachment is in the specified posture, not only the work of selecting the crane of the appropriate type by the user but also the work of preparing a construction plan using the crane are facilitated.

In the construction work planning support device of the present invention,
it is preferable that

the first planning support processing element further recognizes a spatial margin around the material, and
the type selection support processing element determines sufficiency of the first specified condition, based on the spatial margin, in addition to the space occupancy mode of the building, the topography of the specified place included in the area around the building and the space occupancy mode of the material recognized by the first planning support processing element.

According to the construction work planning support device of the configuration, the work of selecting the crane of the type satisfying the first specified condition by the user is made possible in the form of considering the spatial margin (such as a hook hoist limit distance and a sling length) in addition to the space occupancy mode of the building, the topography of the specified place where the crane is to be arranged and the space occupancy mode of the material.

In the construction work planning support device of the present invention,
it is preferable that

the first planning support processing element further recognizes mass of the material, and
the type selection support processing element determines presence/absence of the crane of the type satisfying the specified conditions further including a third specified condition of having a rated load equal to or larger than the mass of the material recognized by the first planning support processing element.

According to the construction work planning support device of the configuration, the "third specified condition" included in the specified conditions is the condition of having the rated load equal to or larger than the mass of the material. Therefore, from the perspective of stably lifting the material in the state where the crane is arranged at the specified place and the attachment is in the specified posture, not only the work of selecting the crane of the appropriate type by the user but also the work of preparing a construction plan using the crane are facilitated.

In the construction work planning support device of the present invention,
it is preferable that

the first planning support processing element further recognizes mass of the material, and
the type selection support processing element determines presence/absence of the crane of the type satisfying the specified conditions further including a fourth specified condition of having a hook corresponding to the mass of the material.

According to the construction work planning support device of the configuration, the "fourth specified condition" included in the specified conditions is the condition of having the hook according to the mass of the material. Therefore, from the perspective of stably lifting the material to the hook in the state where the crane is arranged at the specified place and the attachment is in the specified posture, not only the work of selecting the crane of the appropriate type by the user but also the work of preparing a construction plan using the crane are facilitated.

In the construction work planning support device of the present invention, it is preferable that

the type selection support processing element determines presence/absence of a combination of the crane of the type satisfying the specified conditions and the specified place, and

the second planning support processing element makes the output interface output information regarding the combination of the crane of the type and the specified place, when it is determined by the type selection support processing element that the combination of the crane of the type satisfying the specified conditions and the specified place is present.

According to the construction work planning support device of the configuration, when the combination of the crane of the type satisfying the specified conditions and the specified place where the crane is to be arranged is present, the information regarding the combination is outputted by the output interface. Thus, from the perspective of lifting the material from the material yard of the building or the like, the work of selecting the crane of the appropriate type by the user and the work of preparing a construction plan including an arrangement plan of the crane are facilitated.

In the construction work planning support device of the present invention, it is preferable that

the first planning support processing element recognizes the specified place inputted through an input interface, and the type selection support processing element determines presence/absence of the combination of the crane of the type satisfying the specified conditions and a new specified place, when it is determined that the crane of the type satisfying the specified conditions is not present for the specified place recognized by the first planning support processing element.

According to the construction work planning support device of the configuration, from the perspective of lifting the material from the material yard of the building or the like, the work of selecting the crane of the appropriate type by the user and the work of preparing a construction plan including an arrangement plan of the crane are facilitated.

In the construction work planning support device of the present invention, it is preferable that

the second planning support processing element makes the output interface output the space occupancy mode of the building and the space occupancy mode when lifting the material, and the first planning support processing element recognizes the specified place or the topography of the specified place inputted through an input interface by a user in contact with the output interface.

According to the construction work planning support device of the configuration, it is possible to make the user recognize the space occupancy mode of each of the building and the material as a suspended load through the output interface, and make the user specify a crane arrangement place through the input interface. Therefore, from the perspective of lifting the material from the material yard of the building or the like, the work of selecting the crane of the appropriate type by the user and the work of preparing a construction plan including an arrangement plan of the crane are facilitated.

Brief Description of Drawings

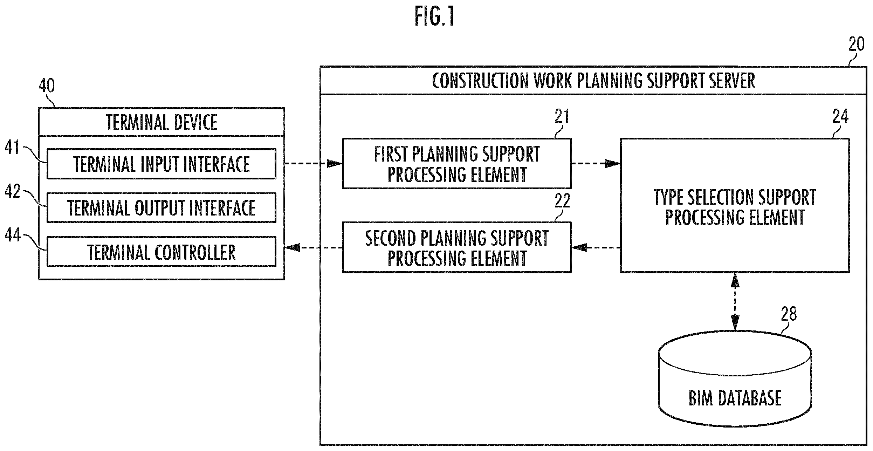

[FIG. 1] FIG. 1 is a configuration explanatory drawing of a construction work planning support device.
[FIG. 2] FIG. 2 is a schematic explanatory drawing of a crane.
[FIG. 3] FIG. 3 is a configuration explanatory drawing of the crane.
[FIG. 4] FIG. 4 is a flowchart illustrating a crane selecting method.
[FIG. 5] FIG. 5 is an explanatory drawing regarding a first specified condition.
[FIG. 6] FIG. 6 is an explanatory drawing regarding a second specified condition.
[FIG. 7] FIG. 7 is an explanatory drawing regarding recommendation of crane arrangement mode.

Description of Embodiments

(Configuration of construction work planning support device)

A construction work planning support server 20 configuring the construction work planning support device is configured by one or more servers connected with a terminal device 40 in an intercommunicable manner via a network.

The construction work planning support server 20 comprises a first planning support processing element 21, a second planning support processing element 22, a type selection support processing element 24, and a BIM database 28. The BIM database 28 may be configured by a database server different from the server configuring the construction work planning support server 20.

Each of the first planning support processing element 21, the second planning support processing element 22 and the type selection support processing element 24 is configured by one or more arithmetic processing units (such as CPUs, single-processor cores and multi-processor cores). The arithmetic processing unit has a function of reading data and a program (computer software) stored in a storage device (such as a memory and a hard disk) and executing arithmetic processing according to the program based on the data.

The terminal device 40 is configured by a portable information processor such as a smartphone, a tablet terminal and a laptop computer. The terminal device 40 comprises a terminal input interface 41, a terminal output interface 42, and a terminal controller 44. The terminal input interface 41 is configured by manual operation type keys and/or buttons and a voice recognition device as needed. An expression "A and/or B" means "at least one of A and B". Similarly, the expression "A, B and/or C" means "at least one of A, B and C". The terminal output interface 42 is configured by an image display device and a voice output device as needed. The terminal input interface 41 and the terminal output interface 42 may be configured by a touch panel. The terminal controller 44 is configured by an arithmetic processing unit (such as a CPU, a single-processor core and a multi-processor core). The arithmetic processing unit has the function of reading data and a program (computer software) stored in a storage device (such as a memory and a hard disk) and executing arithmetic processing according to the program based on the data.

(Configuration of crane)

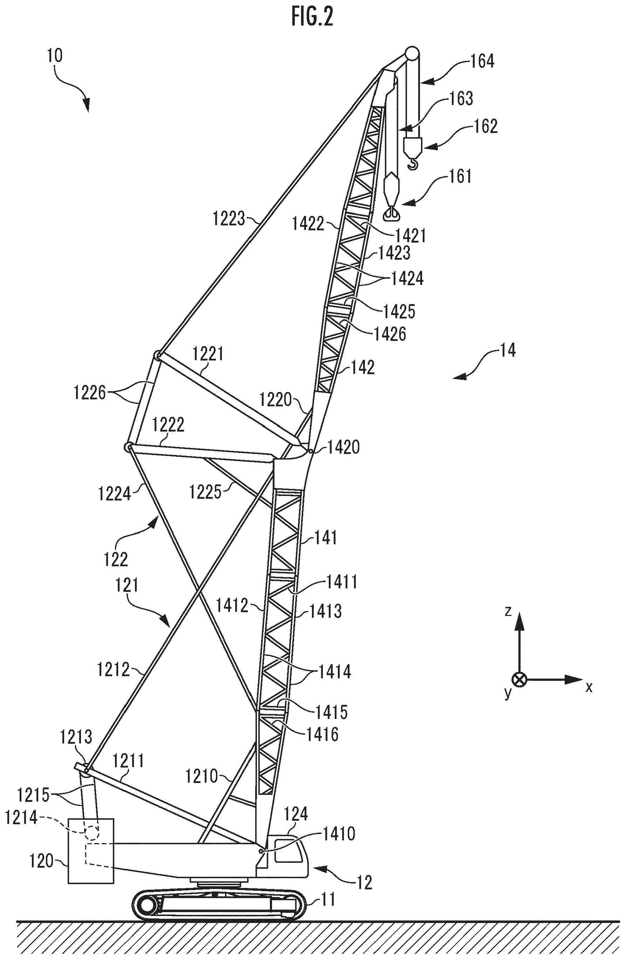

A movable crane 10 as one type illustrated in FIG. 2 comprises a lower traveling body 11, an upper turning body 12, a boom derricking device 121, a jib derricking device 122, a boom 141 and a jib 142. By the lower traveling body 11 and the upper turning body 12, a "crane main body" is configured. By the boom 141 (first attachment element) and the jib 142 (second attachment element), an "attachment 14" is configured. For the crane registered in the BIM database 28, a structure may be simplified more than the actual crane 10.

Kinds and specifications of the crane 10 and the attachment 14 include various things. By the kinds and specifications of the crane 10 and the kinds of the attachment 14, the "type" of the crane 10 is defined. The crane 10 may not be a crawler crane and may be a different movable crane such as a wheel crane (a tire traveling crane, a rough-terrain crane, a track crane, an all-terrain crane) or may be a fixed crane such as a jib crane, a climbing crane or a tower crane. The crane 10 may be a luffing crane or a fixed jib crane other than the tower crane. The jib 142 may be omitted and the crane 10 may comprise the boom 141 as the attachment 14. The boom 141 may be a latticed boom other than a Telesco (R) (telescopic) boom.

An actual machine coordinate system for which a position and a posture are fixed relative to the crane 10 is defined by a z axis parallel to a turning axis of the upper turning body 12 relative to the lower traveling body 11, an x axis parallel to a front-rear direction of the upper turning body 12 and a y axis orthogonal to each of the z axis and the x axis. The actual machine coordinate system is appropriately referred to in order to explain the position and/or the posture of components of the crane 10.

The lower traveling body 11 has the function of moving relative to a ground surface with which a crawler and/or a wheel is in contact by transmitting power of a motor to the crawler and/or the wheel, for example. The upper turning body 12 is on an upper side of the lower traveling body 11 and is turnably connected to the lower traveling body 11. The upper turning body 12 comprises a counterweight 120 for taking balance in the front-rear direction of the crane 10, and a cab 124 (driver's cab).

The boom 141 is attached so as to perform a derricking motion to both left and right sides of the upper turning body 12 via a pair of left and right boom foot pins 1410 (foot pins) respectively. The boom 141 may be a latticed boom having a lattice structure for which pipes are combined, or may be a telescopic boom having a box-shaped structure.

When the boom 141 is a latticed boom, a cross-sectional shape of the boom 141 vertical to a longitudinal direction of the boom 141 is roughly quadrangular. The boom 141 comprises left and right side faces 1411, a back surface 1412 and a ventral surface 1413. Each of the left and right side faces 1411 of the boom 141 faces each of a left direction (+y direction) and a right direction (-y direction). The back surface 1412 of the boom 141 faces a rear direction (-x direction) of the boom 141 in a state where the boom 141 is raised. The ventral surface 1413 of the boom 141 faces a front direction (+x direction) of the boom 141 in the state.

When the boom 141 is a telescopic boom in a box-shaped structure, the cross-sectional shape of the boom 141 to the longitudinal direction of the boom 141 is roughly quadrangular. In this case, a contour line corresponding to the ventral surface 1413 on the cross section may be a roughly semicircular shape or a roughly circular arc shape. When the boom 141 is a latticed boom, the pipes that configure the boom 141 are main columns 1414, stringers 1415, beams (not illustrated), and braces 1416. The main columns 1414 are the pipes which are arranged at four corner parts of a quadrangle cross section of the boom 141 and extend in the longitudinal direction of the boom 141. The stringers 1415 configure the side faces 1411 and extend in the direction orthogonal to the longitudinal direction of the boom 141 and a horizontal direction Y respectively. The non-illustrated beams are the pipes which configure the back surface 1412 and the ventral surface 1413 and extend in a left-right direction. The braces 1416 configure a surface of the boom 141 and extend in the direction inclined to each of the main columns 1414, the stringers 1415 and the beams.

To each of left and right of the back surface 1412 of the boom 141, each of a pair of left and right boom backstops 1210 is attached. The boom backstops 1210 (backstops) limit a rotation of the boom 141 and consequently limit the rotation in the rear direction of the boom 141 relative to the upper turning body 12. An upper end part of the boom backstops 1210 may be able to be in contact with the boom 141, or may be connected to the boom 141. A lower end part of the boom backstops 1210 may be able to be in contact with the upper turning body 12, or may be connected to the upper turning body 12. At least one end part of the upper end part and the lower end part of the boom backstops 1210 is connected to a structure (the boom 141 or the upper turning body 12) adjacent to the end part. The boom backstops 1210 may be extendable and contractable by a spring, may be extendable and contractable by a hydraulic pressure, or may be extendable and contractable by the spring and the hydraulic pressure. It is same for jib backstops 1220.

The boom derricking device 121 for making the boom 141 perform the derricking motion relative to the crane main body or the upper turning body 12 to the upper turning body 12 comprises a mast 1211, boom guylines 1212 (guylines), an upper spreader 1213, a lower spreader 1214 and a boom derricking rope 1215.

The mast 1211 is attached to the upper turning body 12 so as to perform the derricking motion, and is arranged more in the rear direction than the boom 141. The mast 1211 comprises left and right (two) main columns and a member which connects the left and right main columns with each other.

The boom guylines 1212 (guylines) are connected to a distal end part (an opposite side of a side attached to the upper turning body 12) of the mast 1211 and a distal end part of the boom 141. The boom guylines 1212 are members comprising at least either of a link member (guy link) and a rope (guy rope) (same for jib guylines 1223 and strut guylines 1224 to be described later). The (two) boom guylines 1212 are provided on left and right, and are attached to left and right parts of the boom 141 and the mast 1211 respectively.

The upper spreader 1213 is a device comprising a plurality of sheaves and is arranged at the distal end part of the mast 1211. The lower spreader 1214 is a device comprising a plurality of sheaves and is arranged at a rear direction end part of the upper turning body 12. The boom derricking rope 1215 is put around the lower spreader 1214 and the upper spreader 1213. Therefore, when the boom derricking rope 1215 is wound or paid out by a winch (not illustrated), an interval of the lower spreader 1214 and the upper spreader 1213 changes. As a result, the mast 1211 performs the derricking motion relative to the upper turning body 12. Since the mast 1211 and the boom 141 are connected by the boom guylines 1212, when the mast 1211 performs the derricking motion relative to the upper turning body 12, the boom 141 performs the derricking motion relative to the upper turning body 12.

The jib 142 is connected so as to perform the derricking motion or be rotatable to both left and right sides of the boom 141 via a pair of left and right jib foot pins 1420 (foot pins) respectively. The jib 142 can perform the derricking motion relative to the crane main body or the upper turning body 12 via the boom 141. The jib 142 may be a latticed jib having a lattice structure, or may have a box-shaped structure.

Similarly to the boom 141, the jib 142 comprises left and right side faces 1421, a back surface 1422 and a ventral surface 1423. Similarly to the boom 141, the pipes configuring the jib 142 include main columns 1424, stringers 1425, beams (not illustrated), and braces 1426.

To both left and right sides of the back surface 1422 of the jib 142, a pair of left and right jib backstops 1220 are attached respectively. The jib backstops 1220 (backstops) limit the rotation of the jib 142 and consequently limit the rotation in the rear direction of the jib 142 relative to the boom 141. One end in the longitudinal direction of the jib backstops 1220 may be connected to the jib 142 or may be able to be in contact with the jib 142. The other end (the end on the opposite side of the side connected to the jib 142) in the longitudinal direction of the jib backstops 1220 may be able to be in contact with the distal end part of the boom 141 or may be connected to the distal end part of the boom 141. At least one end part of one end and the other end of the jib backstops 1220 is connected to the structure (the jib 142 or the boom 141) adjacent to the end part.

The jib derricking device 122 for rotating the jib 142 relative to the boom 141 comprises a front strut 1221, a rear strut 1222, jib guylines 1223 (guylines), strut guylines 1224 (guylines) and a jib derricking rope 1226. The struts 1221 and 1222 can perform the derricking motion relative to the distal end part of the boom 141, and are arranged more in the rear direction than the jib 142. The front strut 1221 may be attached to the distal end part of the boom 141 so as to perform the derricking motion, or may be attached to a base end part of the jib 142 so as to perform the derricking motion. The front strut 1221 may have a lattice structure or may have a box-shaped structure. It is the same for the rear strut 1222. On the distal end part of the front strut 1221, a plurality of sheaves are provided. It is the same for the rear strut 1222. The rear strut 1222 is attached to the distal end part of the boom 141 so as to perform the derricking motion. The rear strut 1222 is arranged more in at least either one of the lower direction and the rear direction than the front strut 1221.

Only one strut may be provided or three or more struts may be provided. While a backstop (rear strut backstop 1225) is attached to the rear strut 1222, the backstop may be attached to the front strut 1221.

The jib guylines 1223 (guylines) are connected to the distal end part of the front strut 1221 and the distal end part of the jib 142. The pair of left and right jib guylines 1223 are attached to each of the left side and the right side of each of the jib 142 and the front strut 1221.

The strut guylines 1224 (guylines) are connected to the distal end part of the rear strut 1222 and the boom 141. The pair of left and right strut guylines 1224 are attached to each of the left side and the right side of each of the rear strut 1222 and the boom 141.

The jib derricking rope 1226 is put around the sheaves at the respective distal end parts of the front strut 1221 and the rear strut 1222. Therefore, when the jib derricking rope 1226 is wound or paid out by the non-illustrated winch, an interval of the distal end part of the rear strut 1222 and the distal end part of the front strut 1221 changes. As a result, the front strut 1221 performs the derricking motion relative to the boom 141. Since the front strut 1221 and the jib 142 are connected by the jib guyline 1223, when the front strut 1221 performs the derricking motion relative to the boom 141, the jib 142 performs the derricking motion relative to the boom 141.

Operations of the crane 10 are controlled by an actual machine operation mechanism configured by an operation lever and a pedal or the like arranged inside the cab 124 being operated by an operator riding inside the cab 124. The operations of the crane 10 may be remotely controlled by a remote operation mechanism configured by an operation lever and a pedal or the like configuring a remote operation device being operated by an operator. The crane 10 is driven by a drive mechanism 104 configured by a hydraulic circuit comprising a hydraulic pump, a hydraulic actuator and a control valve or the like, for example.

The crane 10 further comprises a main hoisting hook 161, an auxiliary hoisting hook 162, a main hoisting wire rope 163 for hoisting the main hoisting hook 161, and an auxiliary hoisting wire rope 164 for hoisting the auxiliary hoisting hook 162. By each of the main hoisting wire rope 163 and the auxiliary hoisting wire rope 164 being hoisted or lowered by different winches (not illustrated), each of the main hoisting hook 161 and the auxiliary hoisting hook 162 is elevated and lowered.

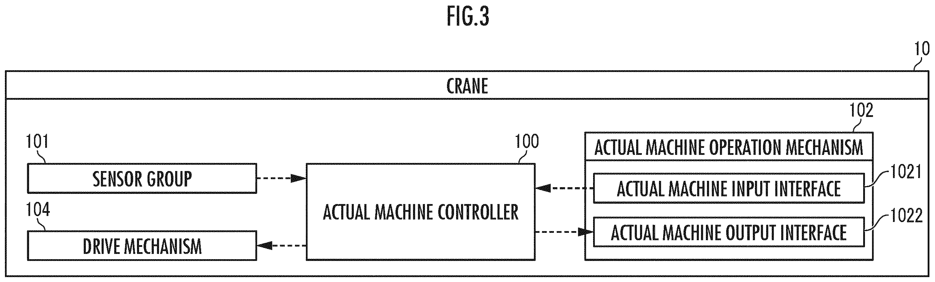

As illustrated in FIG. 3, the crane 10 comprises an actual machine controller 100, a sensor group 101, an actual machine operation mechanism 102 and the drive mechanism 104. The configurations are the configurations provided in the crane 10 (actual machine) of a certain type for which the crane 10 of the type is selected and actually arranged at a work site.

The actual machine operation mechanism 102 is loaded in the cab 124 (driver's cab) configuring a part of the upper turning body 12. The actual machine operation mechanism 102 comprises an actual machine input interface 1021 and an actual machine output interface 1022. The actual machine input interface 1021 is configured by an operation lever and an operation button or the like for the operations of the crane 10, such as a moving operation of the lower traveling body 11 and a turning operation of the upper turning body 12 relative to the lower traveling body 11. The actual machine output interface 1022 is configured by an acoustic output device in addition to an image display device. The operation lever, the operation button and the image display device and the like are arranged around a seat where the operator sits inside the cab 124.

The sensor group 101 is configured by a sensor for measuring an elevation angle (or a derricking angle) and an azimuth of the boom 141 around the boom foot pins 1410, a sensor for measuring a turning angle (or a derricking angle) and an azimuth of the jib 142 around the jib foot pins 1420, a sensor for measuring tension generated to a wire for the suspended load and a paid-out length of the wire, and a sensor for measuring a turning angle of the upper turning body 12 relative to the lower traveling body 11 and the like. When the boom 141 is a latticed boom, the sensor for measuring an extension length of the boom 141 is omitted.

The drive mechanism 104 is configured by an actuator and a power transmission mechanism and the like for achieving movement of the lower traveling body 11, turning of the upper turning body 12 relative to the lower traveling body 11, the derricking motion and/or telescopic motion of each of the boom 141 and the jib 142, and winding or payout of the wire ropes 163 and 164 and the like, according to an operation mode of an actual machine operation lever or the like configuring the actual machine input interface 1021.

(Functions)

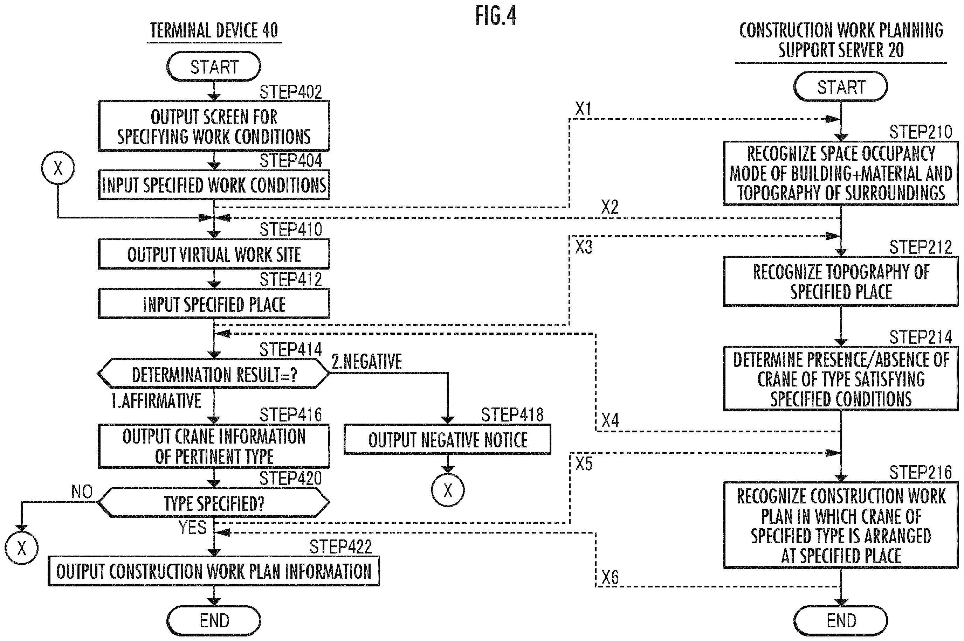

The functions of the construction work planning support server 20 of the configuration described above will be explained using a flowchart in FIG. 4.

As a specified operation such as activation of a specified application (application software) is performed through the terminal input interface 41 in the terminal device 40, a screen for specifying crane work conditions is outputted to the terminal output interface 42 by the terminal controller 44 (FIG. 4/STEP 402). For output of the screen, the terminal device 40 and the construction work planning support server 20 (server) may intercommunicate.

By the terminal controller 44, specified work conditions inputted through the terminal input interface 41 are recognized (FIG. 4/STEP 404). The specified work conditions are identified by a plan name or an area name or the like for specifying one construction plan of a plurality of construction plans registered in the BIM database 28. The work conditions are transmitted from the terminal device 40 and are received by the first planning support processing element 21 in the construction work planning support server 20 (FIG. 4/arrow X1). By the first planning support processing element 21, a space occupancy mode of a building, topography of an area including the building and a space occupancy mode of a material are retrieved or recognized from the BIM database 28, as BIM data according to the construction plan that conforms to the work conditions (FIG. 4/STEP 210).

Input (see FIG. 4/STEP 404) of the specified work conditions through the terminal input interface 41 in the terminal controller 44 may be omitted, and the BIM data according to the specified work conditions determined beforehand may be recognized by the first planning support processing element 21 in the construction work planning support server 20.

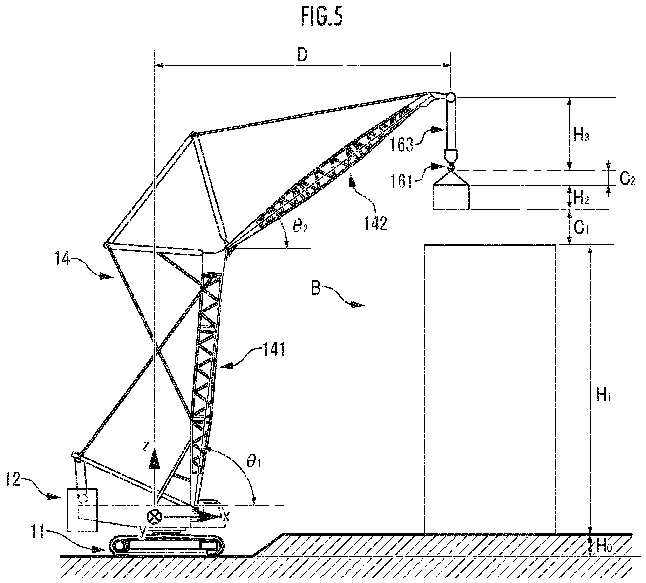

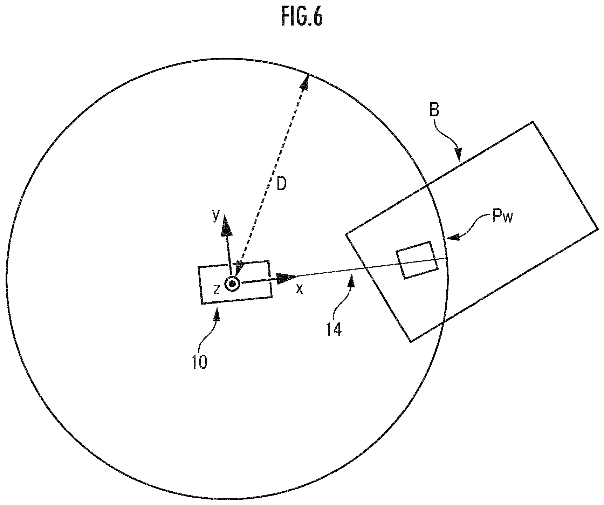

The topography of the area as the BIM data is defined by a combination of an X coordinate value (longitude) and a Y coordinate value (latitude) in a virtual space coordinate system, or a Z coordinate value (altitude or above sea level) of each mesh (a square shape, for example) configuring an X-Y plane. The space occupancy mode of the building as the BIM data is defined by a height $H_1$ (a range of the Z coordinate value in the virtual space coordinate system) from the ground surface of a building B illustrated in FIG. 5 and a size (the range of the X coordinate value and the range of the Y coordinate value in the virtual space coordinate system) in the horizontal direction of the building B illustrated in FIG. 6. Similarly, the space occupancy mode of the material as the BIM data is defined by a height $H_2$ (the range of the Z coordinate value in the virtual space coordinate system) of a material W illustrated in FIG. 5 and the size (the range of the X coordinate value and the range of the Y coordinate value in the virtual space coordinate system) in the horizontal direction of the material W illustrated in FIG. 6.

A z axis direction of the actual machine coordinate system in virtual space may be parallel or may be inclined to a Z axis direction of the virtual space coordinate system. That is, the ground surface of the specified place where the crane 10 is to be arranged in the virtual space may be inclined to the horizontal direction. In this case, sufficiency of the specified condition is determined for the crane of each type by the type selection support processing element 24 in consideration of the inclination angle.

By the second planning support processing element 22, the BIM data is transmitted from the construction work planning support server 20 to the terminal device 40 (FIG. 4/arrow X2). Accordingly, a three-dimensional image indicating a virtual work site corresponding to the BIM data is outputted to the terminal output interface 42 by the terminal controller 44 (FIG. 4/STEP 410). A position of a view point of the three-dimensional image indicating the virtual work site may be arbitrarily adjusted through the terminal input interface 41.

The specified place where the crane is to be arranged in the virtual space is inputted through the terminal input interface 41 (FIG. 4/STEP 412). For example, by specifying one place on the ground surface around the building in the three-dimensional image indicating the virtual work site, which is outputted to the terminal output interface 42, by a click operation in a mouse pointing device configuring the terminal input interface 41, the place is recognized by the terminal controller 44 as the specified place or a specified area.

The specified place is transmitted from the terminal device 40 and is received by the first planning support processing element 21 in the construction work planning support server 20 (FIG. 4/arrow X3). By the first planning support processing element 21, the topography of the specified place is recognized based on the BIM data (FIG. 4/STEP 212). The topography of the specified place is defined by a height $H_0$ of the ground surface of the place where the crane 10 is to be arranged, based on the height of the ground surface where the building B stands in the virtual space, as illustrated in FIG. 4. The height $H_0$ of the ground surface in the area around the building B is defined as a positive value when it is low, as 0 when it is the same and as a negative value when it is high based on the height of the ground surface where the building B stands. The height $H_0$ of the ground surface may be specified by a user through the terminal input interface 41.

By the type selection support processing element 24, presence/absence of the crane of the type satisfying the specified conditions is determined (FIG. 4/STEP 214). The specified conditions include a first specified condition. The "first specified condition" is the condition of having such a load-lifting level that an interval between an upper end of the building and a lower end of the material is equal to or larger than a threshold in the state where the crane 10 is arranged at the specified place and the attachment 14 is in a specified posture. For example, as illustrated in FIG. 5, the state where the specified posture of the attachment 14 is defined by an inclination angle $\theta_1$ to a horizontal plane of the boom 141 and an inclination angle $\theta_2$ to the horizontal plane of the jib 142 is considered. The load-lifting level of the crane 10 is indicated by a sum $H_0+H_1+C_1+H_2+C_2$ of the height $H_0$ of the ground surface of the specified place where the crane 10 is arranged, the height $H_1$ of the building B, an interval Ci in a height direction between the upper end of the building B and the lower end of the material W, the height $H_2$ of the material W and an interval $C_2$ (sling length) in the height direction between the upper end of the material W and the hook 161. The load-lifting level may be the "maximum load-lifting level". In this case, the angle $\theta_1$ corresponds to the maximum derricking angle of the boom 141, and the angle $\theta_2$ corresponds to the maximum derricking angle of the jib 142.

In this state, based on a height H from the ground surface to the jib foot pins 1420, a length Li of the boom 141, a length $L_2$ of the jib 142, a hook hoist limit distance Q and a threshold $C_{1th}$ of the interval Ci between the upper end of the building B and the lower end of the material W, the first specified condition is indicated by a relational expression (01). When the boom 141 performs the telescopic motion, the maximum length Li is taken into consideration as a factor of the crane. Similarly, when the jib 142 performs the telescopic motion, the maximum length $L_2$ is taken into consideration as the factor of the crane.

$$H+L_1\sin\theta_1+L_2\sin\theta_2-Q \geq H_0+H_1+C_{1th}+H_2+C_2 \quad ..(01)$$

Each of the threshold $C_{1th}$, the height $H_2$ of the material W, the interval $C_2$ between the upper end of the material W and the hook 161 and the hook hoist limit distance Q may be recognized by the first planning support processing element 21 by being inputted through the terminal input interface 41 or being retrieved from the BIM database 28. The interval $C_2$ and/or the hook hoist limit distance Q corresponds to a "spatial margin".

The hook hoist limit distance Q may be variably recognized by the first planning support processing element 21 according to mass or maximum mass of the material W recognized by the first planning support processing element 21 by being inputted through the terminal input interface 41 or being retrieved from the BIM database 28.

The specified conditions further include a second specified condition. The "second specified condition" is the condition of having a working radius that includes the building in the state where the crane 10 is arranged at the specified place and a posture of the attachment 14 is the specified posture. For example, as illustrated in FIG. 6, inclusion of a material yard Pw in a circular area of which a center is a turning center axis of the upper turning body 12 and a radius is an interval D from the center to the distal end of the attachment 14 or a jib point pin corresponds to the second specified condition.

Based on an interval d in the horizontal direction from the turning center axis (~a position of the specified place) of the upper turning body 12 to the jib foot pins 1420, the length Li of the boom 141, the length $L_2$ of the jib 142, the hook hoist limit distance Q and an interval $D_0$ in the horizontal direction between the turning center axis of the upper turning body 12 and the material yard, the second specified condition is indicated by a relational expression (02).

$$D=d+L_1\sin\theta_1+L_2\sin\theta_2 \geq D_0 \quad ..(02)$$

A determination result by the type selection support processing element 24 is transmitted from the construction work planning support server 20 by the second planning support processing element 22 and is received by the terminal device 40 (FIG. 4/arrow X4). By the terminal controller 44, whether the determination result is affirmative or negative is determined (FIG. 4/STEP 414). When the determination result is negative (FIG. 4/STEP 414..2), the termination result, that is a notice of determination that the crane of the pertinent type is not present, is outputted to the terminal output interface 42 by the terminal controller 44 (FIG. 4/STEP 418). Thereafter, again, re-input of the specified place where the crane 10 is to be arranged in the virtual space is made possible (see FIG. 4/STEP 412).

On the other hand, when the determination result is affirmative (FIG. 4/STEP 414..1), information regarding the crane of one or more pertinent types is outputted to the terminal output interface 42 by the terminal controller 44 (FIG. 4/STEP 416).

Further, whether or not the crane of the type for which the information is outputted to the terminal output interface 42 is specified within a fixed period of time through the terminal input interface 41 is determined by the terminal controller 44 (FIG. 4/STEP 420). When the determination result is negative (FIG. 4/STEP 420..NO), the re-input of the specified place where the crane 10 is to be arranged in the virtual space is made possible (see FIG. 4/STEP 412).

On the other hand, when the determination result is affirmative (FIG. 4/STEP 420..YES), the information regarding the specified type is transmitted from the terminal device 40 by the terminal controller 44 and is received by the construction work planning support server 20 (FIG. 4/arrow X5). Accordingly, by the second planning support processing element 22, a construction work plan in which the crane of the specified type is arranged at the specified place is recognized (FIG. 4/STEP 216). At the time, the number of deployable cranes of the type registered in the BIM database 28 may be reduced by "1". It is effective when preparing a plan to arrange various kinds of cranes at a plurality of specified places or a plurality of construction work sites even though the number of the deployable cranes is limited.

The information regarding the construction work plan is transmitted from the construction work planning support server 20 by the second planning support processing element 22 and is received by the terminal device 40 (FIG. 4/arrow X6). Accordingly, output is performed to the terminal output interface 42 by the terminal controller 44 (FIG. 4/STEP 422). For example, an image for which the crane 10 arranged at the specified place is superimposed or added to a two-dimensional image or a three-dimensional image indicating the virtual work site according to the BIM data is outputted to the terminal output interface 42 (FIG. 4/STEP 410). The position of the view point of the three-dimensional image indicating the virtual work site including the crane 10 may be arbitrarily adjusted through the terminal input interface 41.

(Effects)

According to the construction work planning support server 20 which demonstrates the functions described above, the information regarding the presence/absence of the crane of the type satisfying the specified conditions is selectively provided to the user such as a construction work planner through the terminal output interface 42 (see FIG. 4/STEP 214→..STEP 416, STEP 418). The presence/absence of the crane of the type is determined in the type group configured by the cranes of the plurality of types registered in the BIM database 28 beforehand.

As described above, the "first specified condition" included in the specified conditions is the condition of having such a load-lifting level that the interval $C_i$ between the upper end of the building B and the lower end of the material W which is the suspended load is equal to or larger than the threshold $C_{1th}$ in the state where the crane 10 is arranged at the specified place in the area around the building B and the attachment 14 is in the specified posture (see FIG. 5 and the relational expression (01)). The "second specified condition" included in the specified conditions is the condition of having a working radius D that includes the material yard of the building B in the state where the crane 10 is arranged at the specified place in the area around the building B and the attachment is in the specified posture (see FIG. 6 and the relational expression (02)).

Therefore, in the state, from the perspective of lifting the material from the material yard Pw of the building B or lowering the material W down to the material yard Pw of the building B while avoiding interference of the building B and the material W for the height direction and moving the material W in the horizontal direction to an upper part of the material yard Pw of the building or moving the material W in the horizontal direction from the upper part of the material yard Pw of the building B, not only the work of selecting the crane of an appropriate type by the user but also the work of preparing a construction plan using the crane are facilitated.

(Other embodiments of present invention)

While the construction work planning support device is configured by the construction work planning support server 20 having an intercommunicating function with the terminal device 40 via a network in the embodiment described above, the construction work planning support device may be configured by the terminal controller 44 of the terminal device 40 as another embodiment. That is, the terminal controller 44 may have the functions as the first planning support processing element 21, the second planning support processing element 22 and the type selection support processing element 24.

The number of times of intercommunication between the terminal device 40 and the construction work planning support server 20 may be changed (see FIG. 4/arrows X1-X6). For example, transmissions X1 and X3 from the terminal device 40 to the construction work planning support server 20 may be gathered into a single transmission and different transmissions X2 and X4 (or the transmissions X2, X4 and X6) from the construction work planning support server 20 to the terminal device 40 may be gathered into the single transmission. In this case, a transmission X5 may be omitted. Further, the transmission X3 from the terminal device 40 to the construction work planning support server 20 may be divided into a plurality of transmissions for specification of each of the plurality of specified conditions.

While the first specified condition and the second specified condition are included in the specified conditions in the embodiment described above, only the first specification condition may be included in the specified conditions.

A "third specified condition" that the crane 10 has a rated load equal to or larger than the mass of the material W may be included in the specified conditions. A "fourth specified condition" of having a hook corresponding to the mass of the material W may be included in the specified conditions. In this case, by the first planning support processing element 21, the mass of the material W which is inputted through the terminal input interface 41 or registered in the BIM database 28 is recognized. For example, when lifting a suspended load W of 120 t, a 150-t hook and a 200-t hook are relevant as the hooks 161 and 162 capable of lifting, and when the 150-t hook is selected, since it is two windings until 130 t and is three windings for 130 t or heavier, the two windings are selected. The fourth specified condition may include that the number of windings corresponding to the selected hook is a specified number.

According to the construction work planning support device of the configuration, from the perspective of stably lifting the material W in the state where the crane 10 is arranged at the specified place and the attachment 14 is in the specified posture (see FIG. 4), not only the work of selecting the crane 10 of the appropriate type by the user but also the work of preparing a construction plan using the crane 10 are facilitated.

The type selection support processing element 24 may determine the presence/absence of a combination of the crane of the type satisfying the specified conditions and the specified place, and the second planning support processing element 22 may make the terminal output interface 42 output the information regarding the combination of the crane of the type and the specified place, when it is determined by the type selection support processing element 24 that the combination of the crane of the type satisfying the specified conditions and the specified place is present. In this case, the first planning support processing element 21 may recognize the specified place inputted through the terminal input interface 41, and the type selection support processing element 24 may determine the presence/absence of the combination of the crane of the type satisfying the specified conditions and a new specified place, when it is determined that the crane of the type satisfying the specified conditions is not present for the specified place recognized by the first planning support processing element 21.

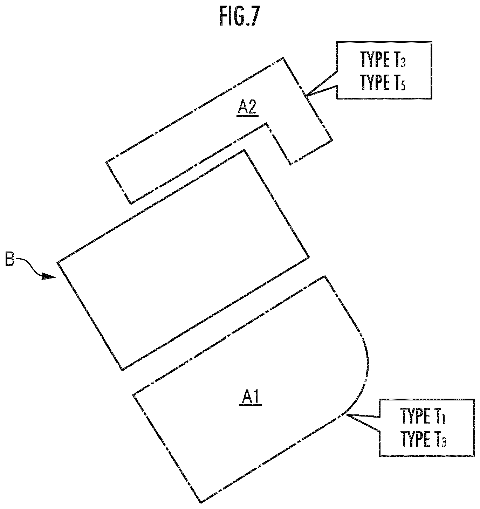

Thus, for example, the terminal output interface 42 may output the information indicating that the cranes of types $T_1$ and $T_3$ are the appropriate cranes satisfying the specified conditions considering the height $H_0$ of the ground surface or the like in a first peripheral area $A_1$ around the building B and the cranes of types $T_3$ and $T_5$ are the appropriate cranes satisfying the specified conditions considering the height $H_0$ of the ground surface or the like in a second peripheral area $A_2$ different from the first peripheral area $A_1$ around the building B, as illustrated in FIG. 7.

According to the construction work planning support device of the configuration, from the perspective of lifting the material W from the material yard of the building B or the like, the work of selecting the crane of the appropriate type by the user and the work of preparing a construction plan including an arrangement plan of the crane are facilitated.

The first planning support processing element 21 may recognize a time sequence of the space occupancy mode of the building B, the topography of the area around the building B and the space occupancy mode when lifting the material W, the type selection support processing element 24 may determine time-sequential presence/absence of the crane of the type satisfying the specified conditions based on the time sequence recognized by the first planning support processing element 21, and the second planning support processing element 22 may make the terminal output interface 42 output the determination result regarding the time-sequential presence/absence of the crane of the type satisfying the specified conditions by the type selection support processing element 24.

According to the construction work planning support device of the configuration, even when the state where the crane 10 is arranged at the specified place in the virtual space and the attachment 14 is in the specified posture time-sequentially changes, from the perspective of lifting the material W or the like while avoiding the interference of the building B and the material W for the height direction, not only the work of selecting the time sequence of the crane of the appropriate type by the user but also the work of preparing a time-sequential construction plan using the crane are facilitated.

Reference Signs List

10..crane, 11..lower traveling body, 12..upper turning body, 14..attachment, 20..construction work planning support device, 21..first planning support processing element, 22..second planning support processing element, 24..type selection support processing element, 28..BIM database, 40..terminal device, 41..terminal input interface, 42..terminal output interface, 44..terminal controller, 100..actual machine controller, 101..sensor group, 102..actual machine operation mechanism, 104..drive mechanism, 124..cab (driver's cab), 141..boom, 142..jib, 1021..actual machine input interface, 1022..actual machine output interface.

**Claims**

1. A construction work planning support device comprising:

   a first planning support processing element configured to recognize a space occupancy mode of a building, topography of an area around the building and a space occupancy mode when lifting a material as a suspended load;
   a type selection support processing element configured to determine, based on the space occupancy mode of the building, the topography of a specified place included in the area around the building and the space occupancy mode of the material recognized by the first planning support processing element, presence/absence of a crane of a type satisfying specified conditions including a first specified condition of having such a load-lifting level that an interval between an upper end of the building and a lower end of the material is equal to or larger than a threshold in a state where the crane is arranged at the specified place and an attachment is in a specified posture; and

a second planning support processing element configured to make an output interface output information regarding a determination result by the type selection support processing element.

2. The construction work planning support device according to claim 1,
wherein the type selection support processing element determines, based on the space occupancy mode of the building and a space coordinate value of the specified place recognized by the first planning support processing element, presence/absence of the crane of the type satisfying the specified conditions further including a second specified condition of having a working radius that includes the building in the state where the crane is arranged at the specified place and a posture of the attachment is the specified posture.

3. The construction work planning support device according to claim 1 or 2,

wherein the first planning support processing element further recognizes a spatial margin around the material, and

the type selection support processing element determines sufficiency of the first specified condition, based on the spatial margin in addition to the space occupancy mode of the building, the topography of the specified place included in the area around the building and the space occupancy mode of the material recognized by the first planning support processing element.

4. The construction work planning support device according to any one of claims 1-3,

wherein the first planning support processing element further recognizes mass of the material, and
the type selection support processing element determines presence/absence of the crane of the type satisfying the specified conditions further including a third specified condition of having a rated load equal to or larger than the mass of the material recognized by the first planning support processing element.

5. The construction work planning support device according to any one of claims 1-4,

wherein the first planning support processing element further recognizes mass of the material, and
the type selection support processing element determines presence/absence of the crane of the type satisfying the specified conditions further including a fourth specified condition of having a hook corresponding to the mass of the material.

6. The construction work planning support device according to any one of claims 1-5,

wherein the type selection support processing element determines presence/absence of a combination of the crane of the type satisfying the specified conditions and the specified place, and

the second planning support processing element makes the output interface output information regarding the combination of the crane of the type and the specified place, when it is determined by the type selection support processing element that the combination of the crane of the type satisfying the specified conditions and the specified place is present.

7. The construction work planning support device according to claim 6,

wherein the first planning support processing element recognizes the specified place inputted through an input interface, and

the type selection support processing element determines presence/absence of the combination of the crane of the type satisfying the specified conditions and a new specified place, when it is determined that the crane of the type satisfying the specified conditions is not present for the specified place recognized by the first planning support processing element.

8. The construction work planning support device according to any one of claims 1-7,

wherein the second planning support processing element makes the output interface output the space occupancy mode of the building and the space occupancy mode when lifting the material, and

the first planning support processing element recognizes the specified place or the topography of the specified place inputted through an input interface by a user in contact with the output interface.

## FIG.1

CONSTRUCTION WORK PLANNING SUPPORT SERVER — 20

TERMINAL DEVICE — 40

TERMINAL INPUT INTERFACE — 41

TERMINAL OUTPUT INTERFACE — 42

TERMINAL CONTROLLER — 44

FIRST PLANNING SUPPORT PROCESSING ELEMENT — 21

SECOND PLANNING SUPPORT PROCESSING ELEMENT — 22

TYPE SELECTION SUPPORT PROCESSING ELEMENT — 24

BIM DATABASE — 28

# FIG.2

FIG.3

EP 4 216 146 A1

**FIG.4**

TERMINAL DEVICE 40

START

STEP402
OUTPUT SCREEN FOR
SPECIFYING WORK CONDITIONS

STEP404
INPUT SPECIFIED WORK CONDITIONS

STEP410
OUTPUT VIRTUAL WORK SITE

STEP412
INPUT SPECIFIED PLACE

STEP414
DETERMINATION RESULT=?
1.AFFIRMATIVE    2.NEGATIVE

STEP416
OUTPUT CRANE INFORMATION
OF PERTINENT TYPE

STEP418
OUTPUT NEGATIVE NOTICE

STEP420
TYPE SPECIFIED?
NO    YES

STEP422
OUTPUT CONSTRUCTION WORK PLAN INFORMATION

END

CONSTRUCTION WORK PLANNING
SUPPORT SERVER 20

START

STEP210
RECOGNIZE SPACE OCCUPANCY
MODE OF BUILDING+MATERIAL AND
TOPOGRAPHY OF SURROUNDINGS

STEP212
RECOGNIZE TOPOGRAPHY OF
SPECIFIED PLACE

STEP214
DETERMINE PRESENCE/ABSENCE OF
CRANE OF TYPE SATISFYING
SPECIFIED CONDITIONS

STEP216
RECOGNIZE CONSTRUCTION WORK
PLAN IN WHICH CRANE OF
SPECIFIED TYPE IS ARRANGED
AT SPECIFIED PLACE

END

X1
X2
X3
X4
X5
X6

EP 4 216 146 A1

# FIG.5

FIG.6

# FIG.7

TYPE T$_3$
TYPE T$_5$

A2

B

A1

TYPE T$_1$
TYPE T$_3$

## INTERNATIONAL SEARCH REPORT

International application No.

**PCT/JP2021/038280**

| A. | CLASSIFICATION OF SUBJECT MATTER |
|---|---|

*G06Q 50/08*(2012.01)i; *B66C 13/00*(2006.01)i

FI: G06Q50/08; B66C13/00 Z

According to International Patent Classification (IPC) or to both national classification and IPC

| B. | FIELDS SEARCHED |
|---|---|

Minimum documentation searched (classification system followed by classification symbols)

G06Q10/00 - 99/00; B66C13/00

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 2004-239050 A (KAJIMA CORP.) 26 August 2004 (2004-08-26) paragraphs [0021]-[0072] | 1-8 |

☐ Further documents are listed in the continuation of Box C.  ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **07 January 2022** | **18 January 2022** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 **Japan** | |
| | Telephone No. |

Form PCT/ISA/210 (second sheet) (January 2015)

INTERNATIONAL SEARCH REPORT
Information on patent family members

International application No.

**PCT/JP2021/038280**

| Patent document cited in search report | Publication date (day/month/year) | Patent family member(s) | Publication date (day/month/year) |
|---|---|---|---|
| JP 2004-239050 A | 26 August 2004 | (Family: none) | |

Form PCT/ISA/210 (patent family annex) (January 2015)

**EP 4 216 146 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002099589 A